(19) **Europäisches Patentamt / European Patent Office / Office européen des brevets**

(11) **EP 3 386 929 B1**

(12) **FASCICULE DE BREVET EUROPEEN**

(45) Date de publication et mention de la délivrance du brevet:
**22.04.2020 Bulletin 2020/17**

(21) Numéro de dépôt: **16819622.8**

(22) Date de dépôt: **08.12.2016**

(51) Int Cl.:
*C03C 17/00* (2006.01)   *C23C 14/00* (2006.01)
*C23C 14/08* (2006.01)   *C23C 14/10* (2006.01)
*C23C 14/18* (2006.01)   *C23C 14/35* (2006.01)
*C23C 16/00* (2006.01)   *C23C 16/40* (2006.01)
*C23C 16/513* (2006.01)

(86) Numéro de dépôt international:
**PCT/FR2016/053277**

(87) Numéro de publication internationale:
**WO 2017/098166 (15.06.2017 Gazette 2017/24)**

(54) **PROCÉDÉ ET INSTALLATION POUR L'OBTENTION D'UN VITRAGE COLORÉ**

**VERFAHREN UND ANLAGE ZUM ERHALT EINER FARBIGEN VERGLASUNG**

**PROCESS AND PLANT FOR OBTAINING COLORED GLAZING**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.12.2015 FR 1562045**

(43) Date de publication de la demande:
**17.10.2018 Bulletin 2018/42**

(73) Titulaire: **Saint-Gobain Glass France 92400 Courbevoie (FR)**

(72) Inventeurs:
• **MAGDENKO-SAVOUREY, Liubov**
  **60260 Lamorlaye (FR)**
• **AGUIAR, Rosiana**
  **78180 Montigny Le Bretonneux (FR)**

(74) Mandataire: **Saint-Gobain Recherche Département Propriété Industrielle 39 Quai Lucien Lefranc 93300 Aubervilliers (FR)**

(56) Documents cités:
US-A- 5 876 854       US-A- 5 976 678
US-A1- 2001 018 393   US-A1- 2015 325 418

• CHAN KEE WAH ET AL: "Effect of rapid thermal annealing time on Au/SiOxfilm prepared by hot wire assisted plasma enhanced chemical vapour deposition technique", MATERIALS CHEMISTRY AND PHYSICS, ELSEVIER SA, SWITZERLAND, TAIWAN, REPUBLIC OF CHINA, vol. 140, no. 1, 30 mars 2013 (2013-03-30) , pages 37-41, XP028534003, ISSN: 0254-0584, DOI: 10.1016/J.MATCHEMPHYS.2013.02.025
• BEYENE H T ET AL: "Plasma-Assisted Deposition of Au/SiOMulti-layers as Surface Plasmon Resonance-Based Red-Colored Coatings", PLASMONICS, KLUWER ACADEMIC PUBLISHERS-PLENUM PUBLISHERS, NE, vol. 6, no. 2, 8 janvier 2011 (2011-01-08) , pages 255-260, XP019902956, ISSN: 1557-1963, DOI: 10.1007/S11468-010-9197-9
• MIEWON JUNG: "Synthesis and Structural Analysis of Au-Doped TiO2/SiO2 Mixed Oxide Films Prepared by Sol-Gel Process", JOURNAL OF SOL-GEL SCIENCE AND TECHNOLOGY, KLUWER ACADEMIC PUBLISHERS, BO, vol. 19, no. 1-3, 1 décembre 2000 (2000-12-01), pages 563-568, XP019212706, ISSN: 1573-4846, DOI: 10.1023/A:1008748924836

- DANIEL ET AL: "Description of a hybrid PECVD-PVD process: Application to Zn-Si-O and Ti-Si-O composites thin films", APPLIED SURFACE SCIENCE, ELSEVIER, AMSTERDAM, NL, vol. 253, no. 24, 11 septembre 2007 (2007-09-11), pages 9323-9329, XP022241134, ISSN: 0169-4332, DOI: 10.1016/J.APSUSC.2007.05.063

**Description**

La présente invention est relative à un procédé et une installation dans le domaine du traitement de surface d'un substrat verrier de manière à y déposer un revêtement lui conférant une coloration adaptée, sans avoir à ajouter dans la composition initiale du verre des oxydes métalliques supplémentaires. D'une manière générale, ledit traitement vise à modifier l'aspect de surface d'un vitrage, notamment d'un verre plat incolore issu d'un procédé industriel du type verre float, pour lui conférer une coloration après sa mise en forme, par le simple dépôt d'un revêtement en couche mince, ledit revêtement étant constitué dans un matériau présentant un pic d'absorption plasmonique dans le domaine du visible.

Dans le domaine des vitrages pour bâtiments, de nombreuses recherches sont consacrées au développement de vitrages innovants et aux propriétés variées : vitrages pour le contrôle solaire, vitrages autonettoyants ou encore verres colorés. De plus en plus, on recherche également des vitrages combinant plusieurs propriétés, et notamment des vitrages colorés ayant une ou plusieurs fonctionnalités comme le contrôle solaire, l'isolation thermique (vitrages bas-émissifs), le blindage électromagnétique, le chauffage, les fonctions hydrophile ou hydrophobe, le photocatalytique (vitrages autonettoyants), la modification du niveau de réflexion dans le visible (vitrages anti-reflets ou miroirs).

Lorsque l'on souhaite obtenir des verres colorés, le procédé industriel actuel consiste à ajouter des pigments - généralement des oxydes métalliques - dans le bain de fusion du verre float. Au moment de la fabrication du verre, des oxydes métalliques variés peuvent ainsi être utilisés suivant la couleur finale souhaitée du vitrage: CuO pour une coloration rouge, MnO pour du violet ou encore CoO pour du bleu. On obtient ainsi des verres colorés dans leur masse.

Bien que ce procédé soit relativement simple à mettre en œuvre, il présente un inconvénient majeur. L'utilisation de pigments au moment de l'élaboration du verre contamine le bain de fusion et implique que l'on doive fabriquer une couleur adaptée dans un bain spécifique.

En particulier, un changement de couleur nécessite toujours la fabrication d'un verre de transition : une quantité important de verre est ainsi perdue jusqu'à l'obtention de la coloration voulue. Ceci implique une perte importante au niveau de la production, ainsi que de la productivité de l'installation, avec au final une augmentation sensible du coût du vitrage si l'on souhaite en modifier la coloration. Ce procédé manque donc de flexibilité pour s'adapter à une demande en perpétuel changement de la part des clients.

Une solution avantageuse permettant d'augmenter la flexibilité dans la production de tels verres colorés consiste à y déposer un revêtement en couche(s), les caractéristiques colorimétriques dudit revêtement étant dans ce cas facilement ajustables et modifiables.

L'objet de la présente invention est ainsi, selon un premier aspect, de proposer un procédé simple et une installation permettant de le mettre en œuvre, ledit procédé permettant le dépôt d'un tel revêtement dont la colorimétrie est facilement ajustable.

De façon connue, le revêtement d'un substrat par une ou plusieurs couches minces en phase vapeur d'un matériau déterminé peut être effectué selon plusieurs techniques différentes :

Selon une première méthode dite de pyrolyse, les précurseurs des produits à déposer, apportés sous forme gaz, liquide ou solide sont décomposés sur le substrat chaud (T > 500°C). Dans le cas de précurseurs gazeux, on désigne la méthode sous le terme AP-CVD (Atmospheric Pressure Chemical Vapor Déposition) ou plus généralement CVD thermique. La présente invention ne se rapporte pas à de tels procédés.

Selon une seconde méthode de dépôt, on utilise les procédés dits de pulvérisation cathodique ou encore « pulvérisation magnétron » qui consistent à effectuer, dans un vide secondaire et sous champ magnétique, le dépôt par pulvérisation du matériau ou d'un précurseur du matériau à déposer. Un exemple de réalisation d'un tel dispositif est par exemple décrit dans le brevet US 6,214,183.

Un troisième procédé, initialement développé dans le domaine de la micro-électronique et appelé PE-CVD (pour Plasma Enhanced Chemical Vapor Déposition) a été décrit. Selon ce procédé, à la place de l'utilisation d'une cible faite du matériau à déposer, des précurseurs de celui-ci sont injectés sous forme d'un gaz et décomposés dans la décharge électrique du plasma. Ce procédé est généralement effectué à des pressions de l'ordre de 10 mTorr à 500 mbar (1Torr = 133 Pa, 1 bar = 0,1 MPa). Le substrat est en général utilisé à température ambiante ou chauffé à des températures relativement basses (par exemple inférieures à 350°C) pour assurer les propriétés mécaniques et d'adhérence de la couche déposée. Cette technique peut être utilisée, du fait de la température modérée imposée au substrat, pour le revêtement de substrats sensibles à la température, par exemple constitués de polymères plastiques. Un procédé de cette nature est par exemple décrit dans la demande EP 0 149 408.

Les procédés de pulvérisation magnétron et dans une moindre mesure PE-CVD nécessitent une mise en œuvre dans une installation sous vide et présente de ce fait, pris individuellement, une flexibilité très restreinte.

Comme indiqué précédemment, un des objectif de la présente invention est de remédier aux problèmes précédemment exposés en proposant un procédé de fabrication modulable et qui permette une adaptation flexible et rapide de la colorimétrie recherchée pour le vitrage, ledit procédé étant par ailleurs économique et n'entraînant pas de perte sensible de la production de verre float.

Selon la présente invention, on décrit un procédé combinant les principes de la pulvérisation magnétron et de la PE-CVD, pour permettre le dépôt sur un substrat en principe initialement non coloré (souvent appelé dans le métier verre clair) d'un revêtement lui conférant une couleur adaptable.

La mise en œuvre de la présente invention présente plusieurs avantages. Tout d'abord, la coloration se fait de façon totalement indépendante de la fabrication du verre, en principe incolore selon l'invention (verre non coloré). Ainsi, on peut fabriquer du verre sans devoir prévoir à l'avance sa coloration. Les couches minces permettent aussi d'obtenir des verres colorés en faible quantité ; le présent procédé est ainsi beaucoup plus adaptable à la demande et flexible. Grâce à la présente invention, Il devient possible d'élaborer des couches de différentes couleurs et en différentes proportions et ceci sans perte intermédiaire de grandes quantités de verre.

On connait des procédés de dépôts permettant de réaliser des empilements de couches constituées principalement de nanoparticules métalliques et de couches diélectriques, par les techniques dites de pulvérisation magnétron sous vide d'un cible. Par exemple, la publication « Preparation and optical characterization of Au/SiO2 composite films with multilayer structure, H. B. Liao, Weijia Wen, G. K. L. Wong, Journal of Applied Physics, 2003, Vol. n°93, 4485 » décrit la fabrication d'un empilement $SiO_2$/Au absorbant une longueur d'onde située autour de 530 nm et présentant une couleur rouge en transmission.

La demande WO2010/106370 décrit une méthode pour déposer un revêtement sur un substrat, dans laquelle une solution d'un précurseur est déposée par CVD, AP-CVD ou encore pyrolyse sur un substrat porté à 330-370°C, pour l'obtention d'un film matriciel d'oxyde d'étain, de titane ou de zinc dopé à l'aluminium dans lequel sont intégrée des nanoparticules d'or. Un tel procédé n'apparaît pas assez flexible ni adapté pour une application à l'échelle industrielle, notamment pour la coloration du verre de grande dimension sur des substrats verriers plats issu d'un procédé float dont la largeur est souvent de l'ordre de plusieurs mètres.

Le document Chan Kee Wah et al., Materials Chemistry and Physics, 2013, 140, 37-41 décrit une méthode d'obtention de deux films de $SiO_x$ déposés successivement. Une couche d'or est insérée entre les deux couches de $SiO_x$,

Le document Beyene H et al., Plasmonics, 2011, 6, 255-260 décrit un système multicouche comprenant une succession de couches d'oxyde de silicium et de couches de particules d'argent.

Le document Miewon Jung et al., Journal of Sol-Gel Science and Technology, 2000, 19, 563-568 décrit un procédé dans lequel un film d'un oxyde mixte $TiO_2$/$SiO_2$ dopé à l'or est obtenu au moyen d'un procédé du type sol-gel.

Les documents US 5 876 854 A, US 5 976 678 A et US 2001/018393 décrivent des substrats verriers comprenant des couches colorées.

Le présent procédé permet de manière simple et économique d'obtenir des revêtements en couches colorés et qui absorbe le rayonnement visible incident selon une longueur d'onde facilement ajustable, constitués de nanoparticules métalliques entourées d'une matrice diélectrique, notamment oxyde.

Plus particulièrement, la présente invention se rapporte à un procédé de dépôt d'un revêtement sur un substrat verrier pour en modifier la colorimétrie, ledit procédé étant caractérisé en ce qu'il comprend au moins les étapes suivantes :

a) on fait défiler ledit substrat dans un dispositif de dépôt sous vide par pulvérisation cathodique,
b) on introduit dans ledit dispositif de dépôt sous vide un gaz et on génère un plasma à partir dudit gaz,
c) on pulvérise simultanément, dans une même chambre du dispositif de dépôt sous vide,

- un premier constituant fait dans un matériau constitué d'un oxyde, d'un nitrure ou d'un oxynitrure d'un premier élément, de préférence un oxyde du premier constituant, et
- un second constituant constitué de la forme métallique d'un second élément,

ladite co-pulvérisation étant obtenue au moyen dudit plasma,

d) on introduit dans ledit plasma un hydrure, un halogénure ou un composé organique d'un troisième élément, différent du premier élément,
e) on récupère ledit substrat recouvert dudit revêtement comprenant lesdits premier, second et troisième éléments en sortie du dispositif, ledit revêtement étant constitué de nanoparticules métalliques du second élément dispersées dans une matrice inorganique desdits premier et troisième éléments, notamment sous forme d'un oxyde, d'un nitrure ou d'un oxynitrure desdits premier et troisième éléments, ledit revêtement présentant un pic d'absorption plasmonique dans le domaine du visible,

ou

e') on récupère ledit substrat recouvert dudit revêtement comprenant lesdits premier, second et troisième éléments en sortie du dispositif et on chauffe l'ensemble à une température adaptée (de préférence supérieure à 400° et inférieure à la température de ramollissement du verre) et pendant une durée suffisante pour obtenir un revêtement constitué de nanoparticules métalliques du second élément dispersées dans une matrice inorganique desdits premier et troisième éléments, notamment sous forme d'un oxyde, d'un nitrure ou d'un oxynitrure desdits premier et troisième éléments, ledit revêtement présentant un pic d'absorption plasmonique dans le domaine du visible.

La présente invention concerne ainsi un procédé de dépôt d'un revêtement sur un substrat verrier ledit procédé comprenant une étape dans laquelle on co-pulvérise simultanément par un plasma, dans une même chambre du dispositif de dépôt sous vide, un premier constituant fait dans un matériau constitué d'un oxyde, d'un nitrure ou d'un oxynitrure (de préférence un oxyde) d'un premier élément et d'un second constituant constitué de la forme métallique d'un second élément. Selon l'invention, un hydrure, un halogénure ou un composé organique d'un troisième élément, différent du premier élément est introduit dans ledit plasma, de manière à récupérer ledit substrat recouvert d'un revêtement comprenant lesdits premier, second et troisième éléments en sortie du dispositif. Selon l'invention, ledit revêtement ainsi obtenu est constitué de nanoparticules métalliques du second élément dispersées dans une matrice inorganique desdits premier et troisième éléments et il présente un pic d'absorption plasmonique dans le domaine du visible qui confère une coloration finale au vitrage ainsi obtenu, ladite coloration finale pouvant être obtenue au moyen d'une étape de traitement thermique supplémentaire, si nécessaire.

Ladite coloration est facilement ajustable notamment en modifiant les conditions de ladite pulvérisation et en particulier de la quantité du précurseur du troisième élément introduit dans le plasma.

Selon des réalisations particulières et préférées de la présente invention, qui peuvent bien entendues être combinées entre elles :

- Le premier élément est choisi parmi le titane, le zirconium, l'étain, l'indium, l'aluminium, l'étain ou le silicium, le zinc.
- Le troisième élément, différent du premier élément, est choisi parmi titane, le zirconium, l'étain, l'indium, l'aluminium, l'étain ou le silicium, le zinc.
- Les premier, second et troisième éléments sont différents entre eux.
- Le premier constituant comprend, comprend essentiellement, ou est constitué un oxyde du premier élément.
- La matrice inorganique est un oxyde desdits premier et troisième éléments.
- Le second élément est choisi dans le groupe constitué par : Ag, Au, Ni, Cr, Cu, Pt, Pd, de préférence est choisi parmi Ag, Ni, Cu, de préférence encore parmi Ag ou Au.
- Le gaz plasmagène est un gaz neutre choisi parmi l'argon, le krypton ou l'hélium.
- un gaz réactif comprenant de l'oxygène et/ou de l'azote, en particulier du dioxygène et/ou du diazote, est introduit dans le dispositif, en mélange avec le gaz neutre.
- Selon un premier mode possible, l'étape c) comprend la pulvérisation, dans ledit dispositif de dépôt sous vide par pulvérisation cathodique, d'une cible comprenant des parties constituées d'un mélange d'un oxyde, d'un nitrure ou d'un oxynitrure du premier constituant, de préférence un oxyde du premier constituant, et des parties constituées du métal du second élément.
- La forme métallique du second constituant, selon ce mode, représente entre 10% et 40% du poids total de la cible.
- Selon un mode alternatif possible mais moins préféré, l'étape c) comprend la pulvérisation, dans ledit dispositif de dépôt sous vide par pulvérisation cathodique, d'une première cible constituée d'un oxyde, d'un nitrure ou d'un oxynitrure du premier constituant, de préférence un oxyde du premier constituant, et d'une deuxième cible constituée du métal du second élément.
- Le premier constituant est un oxyde de titane, et ledit second constituant est choisi dans le groupe constitué par Au, Cu, Ag, ou Ni dans lequel le gaz neutre est l'argon, mélangé avec de l'oxygène et dans lequel le second élément est le silicium. Selon ce mode le second élément peut avantageusement être introduit dans ledit dispositif sous la forme d'un organométallique de silicium, de préférence le TEOS ou le HMDSO.
- Le procédé comprend, au cours de l'étape e) un chauffage du substrat jusqu'à une température supérieure à 400° et inférieure à la température de ramollissement. Un tel chauffage est notamment mis en œuvre si il est utile ou nécessaire pour améliorer l'absorption dans le visible du revêtement par l'effet plasmonique.
- L'épaisseur du revêtement est comprise entre 10 et 70 nm, notamment entre 15 et 50 nm.

L'invention se rapporte également à un vitrage susceptible d'être obtenu par le procédé décrit précédemment et comprenant un substrat verrier sur lequel est déposé un revêtement, ledit revêtement étant constitué d'un matériau constitué de nanoparticules dispersées dans une matrice inorganique d'un oxyde, d'un nitrure ou d'un oxynitrure d'au moins deux éléments distincts, ledit matériau présentant un pic d'absorption plasmonique dans le domaine du visible.

En particulier dans un tel vitrage préféré selon l'invention :

- Les deux éléments sont choisis dans le groupe constitué par le titane, le zirconium, l'étain, le zinc ou le silicium et les nanoparticules métalliques sont constituées d'au moins un élément choisi dans le groupe constitué par : Ag, Au, Ni, Cr, Cu, Pt, Pd, de préférence encore parmi Ag, Ni ou Au, de préférence encore parmi Ag ou Au.
- Les nanoparticules métalliques représentent entre 1 et 10 % du poids total du matériau constituant le revêtement, de préférence entre 2 et 10 % du poids total du matériau constituant le revêtement et de manière très préférée entre 2 et 5% du poids total du matériau constituant le revêtement.
- L'épaisseur du revêtement est comprise entre 10 et 50 nm, notamment entre 15 et 50 nm.

- Le premier élément est le silicium et le second élément est choisi dans le groupe constitué par le silicium, le zirconium, l'étain, l'indium, le zinc, le titane et les nanoparticules métalliques sont constituées d'au moins un élément choisi dans le groupe constitué par : Ag, Au, Ni, Cr, Cu, Pt, Pd, de préférence encore parmi Ag, Cu, Ni ou Au, de préférence encore parmi Ag ou Au. De préférence selon ce mode, le troisème élément est le silicium.
- Le premier élément est le titane et un second élément est choisi dans le groupe constitué par le silicium, le zirconium, l'étain, l'indium, le zinc et les nanoparticules métalliques sont constituées d'au moins un élément choisi dans le groupe constitué par : Ag, Au, Ni, Cr, Cu, Pt, Pd, de préférence encore parmi Ag, Cu, Ni ou Au, de préférence encore parmi Ag ou Au. De préférence selon ce mode, le second élément est le titane.

Egalement, l'invention concerne une installation pour la mise en œuvre du procédé décrit précédemment.

Selon une première réalisation, ladite installation comprend en combinaison :

- un dispositif de pulvérisation cathodique comprenant au moins une chambre sous vide,
- une cible constituée d'un mélange d'un premier constituant fait dans un matériau diélectrique constitué d'un oxyde, d'un nitrure ou d'un oxynitrure d'un premier élément et d'un second constituant constitué par la forme métallique d'un second élément, ladite cible étant disposée dans la chambre sous vide,
- des moyens de pulvérisation de ladite cible comprenant des moyens d'introduction d'un gaz plasmagène et des moyens de génération d'un plasma à partir dudit gaz, ledit plasma servant à la pulvérisation de ladite cible,
- des moyens d'introduction dans ledit plasma d'un troisième élément différent du premier élément, sous la forme d'un hydrure, d'un halogénure ou d'un composé organique dudit troisième élément,
- des moyens de défilement du substrat dans ledit dispositif, selon une vitesse adaptée pour le dépôt sur une surface de celui-ci d'une couche d'un revêtement constitué de nanoparticules métalliques du second élément dispersées dans une matrice inorganique d'un oxyde, d'un nitrure ou d'un oxynitrure desdits premier et troisième éléments,
- des moyens de récupération en sortie du dispositif dudit substrat recouvert dudit revêtement.

Selon une seconde réalisation, ladite installation comprenant en combinaison :

- un dispositif de pulvérisation cathodique comprenant au moins une chambre sous vide,
- une première cible constituée d'un mélange d'un premier constituant fait dans un matériau diélectrique constitué d'un oxyde, d'un nitrure ou d'un oxynitrure d'un premier élément, ladite première cible étant disposée dans la chambre sous vide,

- une deuxième cible faite d'un second constituant constitué par la forme métallique d'un second élément, ladite seconde cible étant disposée dans la chambre sous vide,
- des moyens de co-pulvérisation simultanée des deux cibles comprenant des moyens d'introduction d'un gaz plasmagène et des moyens de génération d'un plasma à partir dudit gaz, ledit plasma servant à la pulvérisation desdites cibles,
- des moyens d'introduction dans ledit plasma d'un troisième élément différent du premier élément, sous la forme d'un hydrure, d'un halogénure ou d'un composé organique dudit élément,
- des moyens de défilement du substrat dans ledit dispositif, selon une vitesse adaptée pour le dépôt, sur une surface de celui-ci, d'une couche d'un revêtement constitué de nanoparticules métalliques du second élément dispersées dans une matrice inorganique d'un oxyde, d'un nitrure ou d'un oxynitrure desdits premier et troisième éléments,
- des moyens de récupération en sortie du dispositif dudit substrat recouvert dudit revêtement.

Enfin l'invention se rapport à l'utilisation d'une l'installation telle que précédemment décrite pour la fabrication de substrats verriers colorés comprenant un revêtement constitué de nanoparticules métalliques du second élément dispersées dans une matrice inorganique d'un oxyde, d'un nitrure ou d'un oxynitrure desdits premier et troisième éléments.

Selon l'invention, pour créer le plasma, la cathode peut être alimentée par une alimentation RF (radiofréquence) ou une alimentation DC (courant continu), éventuellement pulsé, ou encore une alimentation AC (courant alternatif). De façon connue, une alimentation RF fournit normalement un courant alternatif de 13,56 MHz. L'utilisation de cette alimentation nécessite une boîte d'accord pour accorder le signal généré vers la cible.

En pratique, lorsqu'on cherchera à pulvériser une cible peu ou pas conductrice, on utilisera préférentiellement une alimentation RF.

Selon le procédé de dépôt selon l'invention, il est également possible, voire préféré, d'utiliser une alimentation DC, qui permet d'obtenir un taux supérieur de pulvérisation, voire d'éviter l'encrassement de la cathode par les composés injectés dans la chambre.

L'invention, ses différents aspects et ses avantages seront mieux compris à la lecture des exemples non limitatifs qui suivent, fournis à titre purement illustratifs.

Dans ces exemples, on cherche à déposer selon le procédé de l'invention une couche colorée constitué d'une matrice d'oxyde des éléments Ti et Si dans laquelle sont dispersées des particules métalliques d'or. Les dépôts des couches colorées selon l'invention sont réalisés dans un bâti de pulvérisation cathodique type magnétron délimitant une chambre dans laquelle un vide secondaire peut être réalisé. Dans ce bâti (constituant l'anode), la cible (constituant la cathode) est installée dans la chambre de telle façon que lors du dépôt, une alimentation RF ou DC permette d'allumer un plasma d'un gaz plasmagène, le plus souvent de l'argon, du krypton ou de l'hélium, devant la cible, le substrat défilant parallèlement à cette cible. Il est possible selon cette installation de choisir la vitesse de défilement du substrat et donc le temps de dépôt et l'épaisseur de la couche.

Pour constituer la cible selon l'invention, on utilise initialement une cible commerciale en oxyde de titane (TiOx). Des pastilles d'or métallique sont fixées (par exemple par collage au moyen d'une colle à l'argent) et régulièrement espacées sur la cible d'oxyde de titane pour constituer la cible à deux constituants selon l'invention, de telle façon que le plasma pulvérise dans le même temps les deux constituants de ladite cible.

On applique sur la cathode la puissance nécessaire à la génération d'un plasma du gaz dans le dispositif. Pour déposer conjointement l'élément Si sur le substrat verrier, un précurseur organométallique du silicium, le HMDSO (héxaméthyldisiloxane), est injecté dans le plasma allumé. Le dépôt se fait sous atmosphère essentiellement d'argon (gaz neutre plasmagène) et d'une faible portion de dioxygène dans la chambre du bâti. Plus précisément, pour tous les exemples qui suivent, le débit d'argon injecté dans la chambre est de 25 sccm (standard cubic centimeters per minute) et le débit d'oxygène injecté dans la chambre est de 10 sccm. Le temps de dépôt est d'environ 6 minutes pour tous les exemples. L'épaisseur des couches ainsi obtenues varie entre 10 et 30 nm.

Plusieurs couches sont déposées selon les mêmes principes en faisant varier le débit du précurseur de silicium afin d'obtenir différentes matrices diélectriques constituées d'un oxyde mixte de titane et de silicium et dans laquelle le rapport des deux éléments Si et Ti s'ajuste, comme indiqué dans le tableau 1 qui suit. Une telle variation dudit rapport permet une variation de l'indice de réfraction de la matrice diélectrique ainsi que l'épaisseur de la couche déposée. La mesure de l'indice de réfraction du revêtement obtenu permet au final d'estimer la quantité de silicium présente dans le matériau constituant ledit revêtement (la couche déposée), un indice mesuré de 2,4 correspondant à un matériau dont la composition est proche de $TiO_2$, un indice mesuré autour de 1,5 correspondant à un matériau dont la composition est proche de $SiO_2$. Le tableau 1 ci-dessous reprend les principaux paramètres de l'étape de dépôt de la couche de revêtement selon le présent procédé.

**Tableau 1**

| Example | Argon (sccm) | O2 (sccm) | HMDSO (sccm) | Puissance (W) | Pression totale (μbar) | Temps de dépôt (mn) |
|---------|--------------|-----------|--------------|---------------|------------------------|---------------------|
| 1 | 25 | 10 | 1 | 500 | 3,47 | 6 |
| 2 | 25 | 10 | 6 | 500 | 3,6 | 6 |
| 3 | 25 | 10 | 8 | 500 | 3,66 | 6 |
| 4 | 25 | 10 | 9 | 500 | 3,68 | 6 |
| 5 | 25 | 10 | 10 | 500 | 3,7 | 6 |
| 6 | 25 | 10 | 12 | 500 | 3,74 | 6 |
| 7 | 25 | 10 | 15 | 500 | 3,82 | 6 |
| 8 | 25 | 10 | 20 | 500 | 4,10 | 6 |

Après le dépôt, les substrats munis des différents revêtements sont recuits à 650°C sous air et à la pression ordinaire.

Pour chaque exemple, les propriétés des revêtements ainsi déposés sont ensuite mesurées selon les protocoles suivants :

Des spectres optiques des échantillons ont été réalisés à l'aide d'un spectrophotomètre Lambda 900 sur la gamme de longueurs d'onde allant de 250 nm à 2500 nm. Des mesures en transmission côté couche et en réflexion côté verre et côté couche sont effectuées. On déduit des mesures le spectre d'absorption et l'éventuelle présence d'un pic d'absorption plasmonique par la relation suivante :

$$A = 100 - T - R \text{ (côté couche).}$$

Les propriétés colorimétriques des couches ont également été mesurées à l'aide du dispositif précédent sur les vitrages obtenus (coté couche). A partir du spectre obtenu, on mesure les valeurs L*, a* et b* (Système international) qui caractérisent le rendu des couleurs.

Les indices de réfraction et les épaisseurs du matériau constituant les revêtements déposés sous forme de couche mince ont été mesurés selon les techniques classiques d'ellipsométrie en utilisant un ellipsomètre à angle variable (VASE).

Pour chacun des exemples, les résultats obtenus sont reportés dans le tableau 2 qui suit.

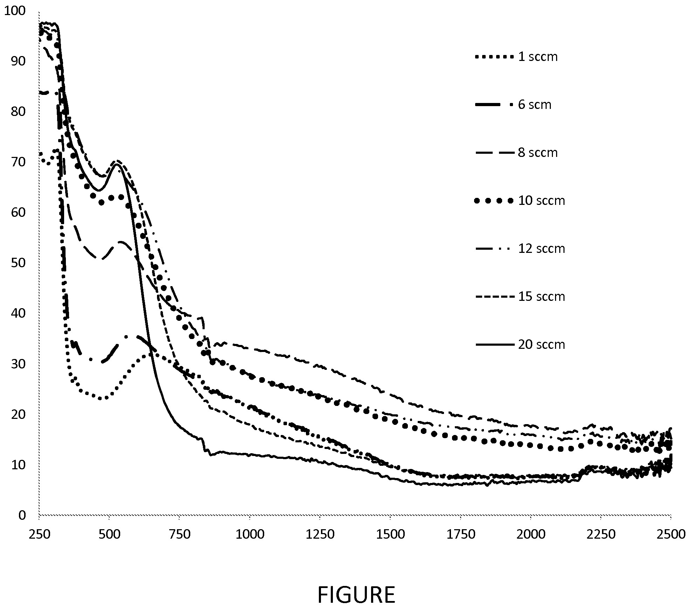

Egalement, sur la figure ci-jointe on a reporté les spectres d'absorption dans le visible des vitrages obtenus selon les exemples précédents (longueur d'onde donnée en nanomètres en abscisse).

**Tableau 2**

| Exemple | Indice de réfraction | HMDSO (sccm) | Colorimétrie | Position pic plasmonique | Couleur perçue |
|---------|---------------------|--------------|--------------|--------------------------|----------------|
| 1 | 2,10 | 1 | L* = 80,3<br>a* = -5,9<br>b* = -3,9 | 650 nm | Cyan |
| 2 | 1,80 | 6 | L* = 55,7<br>a* = -5,0<br>b* = -10 | 580 nm | Bleu clair |
| 3 | 1,69 | 8 | L* = 54,8<br>a* = -2,2<br>b* = -12,1 | 550 nm | Bleu azur |
| 4 | 1,65 | 9 | L* = 52,4<br>a* = -0,6<br>b* = -11,9 | 540 nm | Indigo |
| 5 | 1,63 | 10 | L* = 44,9<br>a* = 1,80<br>b* = -14,4 | 525 nm | Indigo |
| 6 | 1,59 | 12 | L* = 37,7<br>a* = 0,4<br>b* = -21,3 | 520 nm | Bleu nuit |
| 7 | 1,54 | 15 | L* = 41,8<br>a* = 8,7<br>b* = -19,8 | 520 nm | Violet |
| 8 | 1,54 | 20 | L* = 53,6<br>a* = 18,3<br>b* = -10,6 | 520 nm | Magenta |

Les résultats reportés dans le tableau 2 qui précède montrent les avantages liés à la présente invention. En particulier, de façon étonnante et non encore décrite à ce jour, selon un procédé conforme à l'invention, le simple contrôle du débit d'HMDSO (précurseur de l'élément silicium) injecté durant le dépôt permet donc de contrôler la colorimétrie finale du vitrage.

Selon le procédé selon l'invention, il est ainsi possible de contrôler parfaitement et de faire varier dans une large gamme la couleur du vitrage de manière très aisée et économique, sans perte de production.

En particulier, par la simple déposition d'une couche de revêtement, il est possible selon l'invention, par un simple réglage du débit du gaz précurseur dans le dispositif selon l'invention, de modifier rapidement et sans difficultés la coloration du vitrage final (substrat recouvert du revêtement), selon une teinte variant du cyan à différentes teintes et intensités de bleu, mais également des teintes violettes ou magentas.

Des résultats de même nature ont été observé lorsque des pastilles d'argent métallique sont utilisées sur la cible de TiOx en remplacement des pastilles d'or, des colorations encore différentes étant obtenues par un tel remplacement.

A titre d'exemple, on peut également citer la combinaison possible suivante : une cible en oxyde de silicium comprenant une faible quantité d'aluminium (par exemple entre 4 et 12% molaire d'aluminium, sur la base de la quantité de silicium présente) et un précurseur de titane tel que le TiPT (tétraisopropoxyde de titane), le second constituant de la cible étant choisi dans le groupe des métaux constitué par Ag, Au, Ni, Cr, Cu, de préférence étant choisi parmi Ag, Au.

Bien entendu, selon l'invention, il est possible de déposer au-dessus (par référence au substrat verrier), voire en dessous, du revêtement coloré selon l'invention d'autres couches ou d'autres empilements pour conférer au vitrage une fonctionnalité supplémentaire, par exemple de contrôle solaire, bas-émissif, de blindage électromagnétique, de chauffage, hydrophilie, hydrophobie, photocatalyse, anti-reflet ou miroir, électrochromie, électroluminescence, photovoltaïque.

Selon une réalisation préférée de l'invention, on dépose au-dessus du revêtement coloré selon l'invention, voire même en dessous du revêtement coloré, une couche de protection en matériau diélectrique permettant d'augmenter la durabilité mécanique et/ou chimique dudit revêtement, par exemple en nitrure ou oxyde de silicium, ou encore en oxyde de titane. L'épaisseur de cette couche de protection peut par exemple être de l'ordre de 1 à 15 nm, voire de 1 à 10 nm, ou même de 1 à 5 nm.

## Revendications

1. Procédé de dépôt d'un revêtement sur un substrat verrier ledit procédé étant **caractérisé en ce qu'**il comprend les étapes successives suivantes :

   a) on fait défiler ledit substrat dans un dispositif de dépôt sous vide par pulvérisation cathodique,
   b) on introduit dans ledit dispositif de dépôt sous vide un gaz et on génère un plasma à partir dudit gaz,
   c) on co-pulvérise simultanément, dans une même chambre du dispositif de dépôt sous vide,

   - un premier constituant fait dans un matériau constitué d'un oxyde, d'un nitrure ou d'un oxynitrure d'un premier élément et
   - un second constituant constitué de la forme métallique d'un second élément,

   ladite co-pulvérisation étant obtenue au moyen dudit plasma,
   d) on introduit dans ledit plasma un hydrure, un halogénure ou un composé organique d'un troisième élément, différent du premier élément,
   e) on récupère ledit substrat recouvert dudit revêtement comprenant lesdits premier, second et troisième éléments en sortie du dispositif, ledit revêtement étant constitué de nanoparticules métalliques du second élément dispersées dans une matrice inorganique desdits premier et troisième éléments, ledit revêtement présentant un pic d'absorption plasmonique dans le domaine du visible,
   ou
   on récupère ledit substrat recouvert dudit revêtement comprenant lesdits premier, second et troisième éléments en sortie du dispositif et on chauffe l'ensemble à une température adaptée et pendant une durée suffisante pour obtenir un revêtement constitué de nanoparticules métalliques du second élément dispersées dans une matrice inorganique desdits premier et troisième éléments, ledit revêtement présentant un pic d'absorption plasmonique dans le domaine du visible.

2. Procédé selon la revendication 1, dans lequel au cours de l'étape e), la température est supérieure à 400° et inférieure à la température de ramollissement du verre.

3. Procédé selon l'une des revendications précédentes, dans lequel notamment la matrice inorganique est un oxyde, un nitrure ou un oxynitrure desdits premier et troisième éléments.

4. Procédé selon l'une des revendications précédentes, dans lequel le premier élément est choisi parmi le titane, le zirconium, l'étain, l'indium, l'aluminium, l'étain ou le silicium, le zinc.

5. Procédé selon l'une des revendications précédentes, dans lequel le troisième élément est choisi parmi le titane, le zirconium, l'étain, l'indium, l'aluminium, l'étain ou le silicium, le zinc.

6. Procédé selon l'une des revendications précédentes, dans lequel le premier constituant est un oxyde du premier élément.

7. Procédé selon l'une des revendications précédentes, dans lequel le second constituant est choisi dans le groupe des métaux constitué par : Ag, Au, Ni, Cr, Cu, Pt, Pd, de préférence est choisi parmi Ag, Ni, Cu, Au.

8. Procédé selon l'une des revendications précédentes, dans lequel le gaz plasmagène est un gaz neutre choisi parmi l'argon, le krypton ou l'hélium.

9. Procédé selon l'une des revendications précédentes, dans lequel un gaz réactif comprenant de l'oxygène et/ou de l'azote, en particulier du dioxygène et/ou du diazote, est introduit dans le dispositif, en mélange avec le gaz neutre.

10. Procédé selon l'une des revendications précédentes, dans lequel l'étape c) comprend la pulvérisation, dans ledit dispositif de dépôt sous vide par pulvérisation cathodique, d'une cible comprenant des parties constituées d'un mélange d'un oxyde, d'un nitrure ou d'un oxynitrure du premier constituant et des parties constituées de la forme métallique du second constituant.

11. Procédé selon l'une des revendications précédentes, dans lequel l'étape c) comprend la pulvérisation, dans ledit dispositif de dépôt sous vide par pulvérisation cathodique, d'une première cible constituée d'un oxyde, d'un nitrure ou d'un oxynitrure du premier constituant une deuxième cible constituée de la forme métallique du second constituant.

12. Procédé selon l'une des revendications précédentes, dans lequel le premier constituant est un oxyde de titane, dans lequel ledit second constituant est choisi dans le groupe constitué par Au, Ni, Cu, Ag, dans lequel le gaz neutre est l'argon, mélangé avec de l'oxygène et dans lequel le troisième élément est le silicium, ledit silicium étant de préférence introduit dans ledit dispositif sous la forme d'un organométallique de silicium, de préférence le TEOS ou le HMDSO.

13. Procédé selon l'une des revendications précédentes, comprenant l'étape supplémentaire qui consiste à chauffer le substrat jusqu'à une température supérieure à 400° et inférieure à la température de ramollissement du verre au cours de l'étape e).

14. Vitrage susceptible d'être obtenu par le procédé selon l'une des revendications précédentes et comprenant un substrat verrier sur lequel est déposé un revêtement, ledit revêtement étant constitué d'un matériau comprenant des nanoparticules métalliques dispersées dans une matrice inorganique d'un oxyde, d'un nitrure ou d'un oxynitrure, de préférence un oxyde, d'au moins deux éléments différents, ledit matériau présentant un pic d'absorption plasmonique dans le domaine du visible, dans lequel lesdits deux éléments appartiennent au groupe constitué par le titane, le zirconium, l'étain, le zinc ou le silicium, dans lequel les nanoparticules métalliques sont constituées d'au moins un élément choisi dans le groupe constitué par : Ag, Au, Ni, Cr, Cu, Pt, Pd et dans lequel les nanoparticules métalliques représentent entre 1 et 10 % du poids total du matériau constituant le revêtement, de préférence entre 2 et 10 % du poids total du matériau constituant le revêtement et de manière très préférée entre 2 et 5% du poids total du matériau constituant le revêtement, l'épaisseur du revêtement étant comprise entre 10 et 50 nm.

15. Vitrage selon la revendication précédente, dans lequel un premier élément est le silicium et un second élément est choisi dans le groupe constitué par le titane, le zirconium, l'étain, le zinc et les nanoparticules métalliques sont constituées d'au moins un élément choisi dans le groupe constitué par : Ag, Au, Ni, Cr, Cu, Pt, Pd, de préférence encore parmi Ag, Cu, Ni ou Au, de préférence encore parmi Ag ou Au.

16. Vitrage selon la revendication précédente, dans lequel un premier élément est le titane et un second élément est choisi dans le groupe constitué par le silicium, le zirconium, l'étain, l'indium, le zinc et les nanoparticules métalliques sont constituées d'au moins un élément choisi dans le groupe constitué par : Ag, Au, Ni, Cr, Cu, Pt, Pd, de préférence encore parmi Ag, Cu, Ni ou Au, de préférence encore parmi Ag ou Au.

17. Installation pour la mise en œuvre du procédé selon l'une des revendications 1 à 13, ladite installation comprenant en combinaison :

   - un dispositif de pulvérisation cathodique comprenant au moins une chambre sous vide,
   - une cible constituée d'un mélange d'un premier constituant fait dans un matériau diélectrique constitué d'un oxyde, d'un nitrure ou d'un oxynitrure d'un premier élément et d'un second constituant constitué par la forme métallique d'un second élément, ladite cible étant disposée dans la chambre sous vide,
   - des moyens de pulvérisation de ladite cible comprenant des moyens d'introduction d'un gaz plasmagène et des moyens de génération d'un plasma à partir dudit gaz,
   - des moyens d'introduction dans ledit plasma d'un troisième élément différent du premier élément, sous la forme d'un hydrure, d'un halogénure ou d'un composé organique dudit troisième élément,
- des moyens de défilement du substrat dans ledit dispositif, selon une vitesse adaptée pour le dépôt sur une surface de celui-ci d'une couche d'un revêtement constitué de nanoparticules métalliques du second élément dispersées dans une matrice inorganique d'un oxyde, d'un nitrure ou d'un oxynitrure desdits premier et troisième éléments,
- des moyens de récupération en sortie du dispositif dudit substrat recouvert dudit revêtement.

18. Installation pour la mise en œuvre du procédé selon l'une des revendications 1 à 13, ladite installation comprenant en combinaison :

- un dispositif de pulvérisation cathodique comprenant au moins une chambre sous vide,
- une première cible constituée d'un mélange d'un premier constituant fait dans un matériau diélectrique constitué d'un oxyde, d'un nitrure ou d'un oxynitrure d'un premier élément, ladite première cible étant disposée dans la chambre sous vide,
- une deuxième cible faite d'un second constituant constitué par la forme métallique d'un second élément, ladite seconde cible étant disposée dans la chambre sous vide,
- des moyens de co-pulvérisation simultanée des deux cibles comprenant des moyens d'introduction d'un gaz plasmagène et des moyens de génération d'un plasma à partir dudit gaz,
- des moyens d'introduction dans ledit plasma d'un troisième élément différent du premier élément, sous la forme d'un hydrure, d'un halogénure ou d'un composé organique dudit élément,
- des moyens de défilement du substrat dans ledit dispositif, selon une vitesse adaptée pour le dépôt, sur une surface de celui-ci, d'une couche d'un revêtement constitué de nanoparticules métalliques du second élément dispersées dans une matrice inorganique d'un oxyde, d'un nitrure ou d'un oxynitrure desdits premier et troisième éléments,
- des moyens de récupération en sortie du dispositif dudit substrat recouvert dudit revêtement.

19. Utilisation de l'installation selon l'une des revendications 17 ou 18 pour la fabrication de substrats verriers colorés comprenant un revêtement constitué d'une matrice inorganique d'un oxyde, d'un nitrure ou d'un oxynitrure d'un premier et d'un troisième élément, dans laquelle sont dispersées des nanoparticules métalliques d'un second élément.


**Patentansprüche**

1. Verfahren zum Aufbringen einer Beschichtung auf ein Glassubstrat, wobei das Verfahren **dadurch gekennzeichnet ist, dass** es die folgenden aufeinanderfolgenden Schritte umfasst:

a) Führen des Substrats durch eine Vakuumbeschichtungsvorrichtung durch Sputtern,
b) Einleiten, in die Vakuumbeschichtungsvorrichtung, eines Gases und Erzeugen eines Plasmas aus dem Gas,
c) gleichzeitiges Zerstäuben, in derselben Kammer der Vakuumbeschichtungsvorrichtung,

- einer ersten Komponente, gebildet aus einem Material, bestehend aus einem Oxid, einem Nitrid oder einem Oxynitrid eines ersten Elements, und
- einer zweiten Komponente, bestehend aus der metallischen Form eines zweiten Elements,

wobei das gleichzeitige Zerstäuben mittels des Plasmas erhalten wird,
d) Einleiten, in das Plasma, eines Hydrids, eines Halogenids oder einer organischen Verbindung eines dritten Elements, das sich vom ersten Element unterscheidet,
e) Rückgewinnen des mit der Beschichtung bedeckten Substrats, umfassend das erste, zweite und dritte Element, am Ausgang der Vorrichtung, wobei die Beschichtung aus metallischen Nanopartikeln des zweiten Elements besteht, die in einer anorganischen Matrix des ersten und dritten Elements dispergiert sind, wobei die Beschichtung einen Plasmonabsorptionspeak im sichtbaren Bereich aufweist,
oder
Rückgewinnen des mit der Beschichtung bedeckten Substrats, umfassend das erste, zweite und dritte Element, am Ausgang der Vorrichtung, und Erhitzen der Einheit auf eine geeignete Temperatur und während einer Dauer, die ausreicht, um eine Beschichtung zu erhalten, die aus metallischen Nanopartikeln des zweiten Elements besteht, die in einer anorganischen Matrix des ersten und dritten Elements dispergiert sind, wobei die Beschichtung einen Plasmonabsorptionspeak im sichtbaren Bereich aufweist.

2. Verfahren nach Anspruch 1, wobei während Schritt e) die Temperatur höher als 400° und niedriger als die Erweichungstemperatur des Glases ist.

3. Verfahren nach einem der vorhergehenden Ansprüche, wobei insbesondere die anorganische Matrix ein Oxid, ein Nitrid oder ein Oxynitrid des ersten und dritten Elements ist.

4. Verfahren nach einem der vorhergehenden Ansprüche, wobei das erste Element aus Titan, Zirkonium, Zinn, Indium, Aluminium, Zinn oder Silizium, Zink ausgewählt ist.

5. Verfahren nach einem der vorhergehenden Ansprüche, wobei das dritte Element aus Titan, Zirkonium, Zinn, Indium, Aluminium, Zinn oder Silizium, Zink ausgewählt ist.

6. Verfahren nach einem der vorhergehenden Ansprüche, wobei die erste Komponente ein Oxid des ersten Elements ist.

7. Verfahren nach einem der vorhergehenden Ansprüche, wobei die zweite Komponente aus der Gruppe der Metalle ausgewählt ist, die besteht aus: Ag, Au, Ni, Cr, Cu, Pt, Pd, vorzugsweise aus Ag, Ni, Cu, Au ausgewählt ist.

8. Verfahren nach einem der vorhergehenden Ansprüche, wobei das Plasmagas ein neutrales Gas ist, das aus Argon, Krypton oder Helium ausgewählt ist.

9. Verfahren nach einem der vorhergehenden Ansprüche, wobei ein reaktives Gas, das Sauerstoff und/oder Stickstoff, insbesondere molekularen Sauerstoff und/oder molekularen Stickstoff enthält, als Gemisch mit dem neutralen Gas in die Vorrichtung eingeleitet wird.

10. Verfahren nach einem der vorhergehenden Ansprüche, wobei der Schritt c) das Zerstäuben, in der Vakuumbeschichtungsvorrichtung durch Sputtern, eines Targets umfasst, das Teile umfasst, die aus einem Gemisch eines Oxids, eines Nitrids oder eines Oxynitrids der ersten Komponente bestehen und Teile, die aus der metallischen Form der zweiten Komponente bestehen.

11. Verfahren nach einem der vorhergehenden Ansprüche, wobei der Schritt c) das Zerstäuben, in der Vakuumbeschichtungsvorrichtung durch Sputtern, eines ersten Targets umfasst, das aus einem Oxid, einem Nitrid oder einem Oxynitrid der ersten Komponente besteht,eines zweiten Targets, das aus der metallischen Form der zweiten Komponente besteht.

12. Verfahren nach einem der vorhergehenden Ansprüche, wobei die erste Komponente ein Titanoxid ist, wobei die zweite Komponente aus der Gruppe ausgewählt ist, die aus Au, Ni, Cu, Ag besteht, wobei das neutrale Gas Argon ist, gemischt mit Sauerstoff, und wobei das dritte Element Silizium ist, wobei das Silizium vorzugsweise in Form eines metallorganischen Siliziums, vorzugsweise TEOS oder HMDSO, in die Vorrichtung eingeleitet wird.

13. Verfahren nach einem der vorhergehenden Ansprüche, umfassend den zusätzlichen Schritt, der im Erhitzen des Substrats auf eine Temperatur über 400° und unter der Erweichungstemperatur des Glases während des Schritts e) besteht.

14. Verglasung, die durch das Verfahren nach einem der vorhergehenden Ansprüche erhaltbar ist und ein Glassubstrat umfasst, auf dem eine Beschichtung aufgebracht ist, wobei die Beschichtung aus einem Material besteht, das metallische Nanopartikel umfasst, die in einer anorganischen Matrix eines Oxids, eines Nitrids oder eines Oxynitrids, vorzugsweise eines Oxids, von mindestens zwei verschiedenen Elementen dispergiert sind, wobei das Material einen Plasmonabsorptionpeak im sichtbaren Bereich aufweist, wobei die zwei Elemente zu der Gruppe gehören, die aus Titan, Zirkonium, Zinn, Zink oder Silizium besteht, wobei die metallischen Nanopartikel aus mindestens einem Element bestehen, das aus der Gruppe ausgewählt ist, die besteht aus: Ag, Au, Ni, Cr, Cu, Pt, Pd, und wobei die metallischen Nanopartikel zwischen 1 und 10 % des Gesamtgewichts des Materials darstellen, aus dem die Beschichtung besteht, vorzugsweise zwischen 2 und 10 % des Gesamtgewichts des Materials, aus dem die Beschichtung besteht, und ganz besonders bevorzugt zwischen 2 und 5 % des Gesamtgewichts des Materials, aus dem die Beschichtung besteht, wobei die Dicke der Beschichtung zwischen 10 und 50 nm liegt.

15. Verglasung nach vorhergehendem Anspruch, wobei ein erstes Element Silizium ist und ein zweites Element aus der Gruppe ausgewählt ist, die aus Titan, Zirkonium, Zinn, Zink besteht und die metallischen Nanopartikel aus mindestens einem Element bestehen, das aus der Gruppe ausgewählt ist, die besteht aus: Ag, Au, Ni, Cr, Cu, Pt, Pd, vorzugsweise auch aus Ag, Cu, Ni oder Au, vorzugsweise auch aus Ag oder Au.

16. Verglasung nach vorhergehendem Anspruch, wobei ein erstes Element Titan ist und ein zweites Element aus der Gruppe ausgewählt ist, die aus Silizium, Zirkonium, Zinn, Indium, Zink besteht und die metallischen Nanopartikel aus mindestens einem Element bestehen, das aus der Gruppe ausgewählt ist, die besteht aus: Ag, Au, Ni, Cr, Cu, Pt, Pd, vorzugsweise auch aus Ag, Cu, Ni oder Au, vorzugsweise auch aus Ag oder Au.

17. Anlage zur Durchführung des Verfahrens nach einem der Ansprüche 1 bis 13, wobei die Anlage in Kombination umfasst:

- eine Sputtervorrichtung, umfassend mindestens eine Vakuumkammer,
- ein Target, bestehend aus einem Gemisch einer ersten Komponente, gebildet aus einem dielektrischen Material, bestehend aus einem Oxid, einem Nitrid oder einem Oxynitrid eines ersten Elements und einer zweiten Komponente, bestehend aus der metallischen Form eines zweiten Elements, wobei das Target in der Vakuumkammer angeordnet ist,
- Zerstäubungsmittel des Targets, umfassend Mittel zum Einleiten eines Plasmagases und Mittel zum Erzeugen eines Plasmas aus dem Gas,
- Mittel zum Einleiten, in das Plasma, eines dritten Elements, das sich von dem ersten Element unterscheidet, in Form eines Hydrids, eines Halogenids oder einer organischen Verbindung des dritten Elements,
- Mittel zum Führen des Substrats durch die Vorrichtung mit einer Geschwindigkeit, die für das Aufbringen, auf einer Oberfläche desselben, einer Schicht einer Beschichtung geeignet ist, die aus metallischen Nanopartikeln des zweiten Elements besteht, die in einer anorganischen Matrix eines Oxids, eines Nitrids oder eines Oxynitrids des ersten und dritten Elements dispergiert sind,
- Mittel zum Rückgewinnen, am Ausgang der Vorrichtung, des mit der Beschichtung bedeckten Substrats.

18. Anlage zur Durchführung des Verfahrens nach einem der Ansprüche 1 bis 13, wobei die Anlage in Kombination umfasst:

- eine Sputtervorrichtung, umfassend mindestens eine Vakuumkammer,
- ein erstes Target, bestehend aus einem Gemisch einer ersten Komponente, gebildet aus einem dielektrischen Material, bestehend aus einem Oxid, einem Nitrid oder einem Oxynitrid eines ersten Elements, wobei das erste Target in der Vakuumkammer angeordnet ist,
- ein zweites Target, gebildet aus einer zweiten Komponente, bestehend aus der metallischen Form eines zweiten Elements, wobei das zweite Target in der Vakuumkammer angeordnet ist,
- Mittel zum gleichzeitigen Zerstäuben der beiden Targets, umfassend Mittel zum Einleiten eines Plasmagases und Mittel zum Erzeugen eines Plasmas aus dem Gas,
- Mittel zum Einleiten, in das Plasma, eines dritten Elements, das sich von dem ersten Element unterscheidet, in Form eines Hydrids, eines Halogenids oder einer organischen Verbindung des Elements,
- Mittel zum Führen des Substrats durch die Vorrichtung mit einer Geschwindigkeit, die für das Aufbringen, auf einer Oberfläche desselben, einer Schicht einer Beschichtung geeignet ist, die aus metallischen Nanopartikeln des zweiten Elements besteht, die in einer anorganischen Matrix eines Oxids, eines Nitrids oder eines Oxynitrids des ersten und dritten Elements dispergiert sind,
- Mittel zum Rückgewinnen, am Ausgang der Vorrichtung, des mit der Beschichtung bedeckten Substrats.

19. Verwendung der Anlage nach einem der Ansprüche 17 oder 18 zur Herstellung von farbigen Glassubstraten, umfassend eine Beschichtung, die aus einer anorganischen Matrix eines Oxids, eines Nitrids oder eines Oxynitrids eines ersten und eines dritten Elements besteht, in der metallische Nanopartikel eines zweiten Elements dispergiert sind.

**Claims**

1. A process for depositing a coating on a glass substrate, said process being **characterized in that** it comprises the following successive steps:

a) passing said substrate through a device for vacuum deposition by cathode sputtering,
b) introducing a gas into said vacuum deposition device and generating a plasma from said gas,

c) co-sputtering simultaneously, in one and the same chamber of the vacuum deposition device,

- a first constituent made of a material consisting of an oxide, a nitride or an oxynitride of a first element and
- a second constituent consisting of the metallic form of a second element,

said co-sputtering being obtained by means of said plasma,

d) introducing a hydride, a halide or an organic compound of a third element, different than the first element, into said plasma,

e) recovering said substrate, covered with said coating comprising said first, second and third elements, at the outlet of the device, said coating consisting of metal nanoparticles of the second element dispersed in an inorganic matrix of said first and third elements, said coating displaying a plasmon absorption peak in the visible region,

or

recovering said substrate covered with said coating comprising said first, second and third elements at the outlet of the device and heating the whole at a suitable temperature and for a sufficient time to obtain a coating consisting of metal nanoparticles of the second element dispersed in an inorganic matrix of said first and third elements, said coating displaying a plasmon absorption peak in the visible region.

2. The process as claimed in claim 1, in which, during step e), the temperature is above 400° and below the softening point of the glass.

3. The process as claimed in one of the preceding claims, in which in particular the inorganic matrix is an oxide, a nitride or an oxynitride of said first and third elements.

4. The process as claimed in one of the preceding claims, in which the first element is selected from titanium, zirconium, tin, indium, aluminum, tin or silicon, zinc.

5. The process as claimed in one of the preceding claims, in which the third element is selected from titanium, zirconium, tin, indium, aluminum, tin or silicon, zinc.

6. The process as claimed in one of the preceding claims, in which the first constituent is an oxide of the first element.

7. The process as claimed in one of the preceding claims, in which the second constituent is selected from the group of metals consisting of: Ag, Au, Ni, Cr, Cu, Pt, Pd, and preferably is selected from Ag, Ni, Cu, Au.

8. The process as claimed in one of the preceding claims, in which the plasma gas is a neutral gas selected from argon, krypton or helium.

9. The process as claimed in one of the preceding claims, in which a reactive gas comprising oxygen and/or nitrogen, in particular dioxygen and/or dinitrogen, is mixed with the neutral gas and introduced into the device.

10. The process as claimed in one of the preceding claims, in which step c) comprises the sputtering, in said device for vacuum deposition by cathode sputtering, of a target comprising parts consisting of a mixture of an oxide, a nitride or an oxynitride of the first constituent and parts consisting of the metallic form of the second constituent.

11. The process as claimed in one of the preceding claims, in which step c) comprises the sputtering, in said device for vacuum deposition by cathode sputtering, of a first target consisting of an oxide, a nitride or an oxynitride of the first constituent and of a second target consisting of the metallic form of the second constituent.

12. The process as claimed in one of the preceding claims, in which the first constituent is a titanium oxide, in which said second constituent is selected from the group consisting of Au, Ni, Cu, Ag, in which the neutral gas is argon, mixed with oxygen and in which the third element is silicon, said silicon preferably being introduced into said device in the form of an organometallic silicon compound, preferably TEOS or HMDSO.

13. The process as claimed in one of the preceding claims, comprising the additional step that consists of heating the substrate to a temperature above 400° and below the softening point of the glass during step e).

14. Glazing obtainable by the process as claimed in one of the preceding claims and comprising a glass substrate on which a coating is deposited, said coating consisting of a material comprising metal nanoparticles dispersed in an inorganic matrix of an oxide, a nitride or an oxynitride, preferably an oxide, of at least two different elements, said material displaying a plasmon absorption peak in the visible region, in which said two elements belong to the group consisting of titanium, zirconium, tin, zinc or silicon, in which the metal nanoparticles consist of at least one element selected from the group consisting of: Ag, Au, Ni, Cr, Cu, Pt, Pd and in which the metal nanoparticles represent between 1 and 10% of the total weight of the material constituting the coating, preferably between 2 and 10% of the total weight of the material constituting the coating and very preferably between 2 and 5% of the total weight of the material constituting the coating, the thickness of said coating being comprised between 10 and 50 nm.

15. The glazing as claimed in the preceding claim, in which a first element is silicon and a second element is selected from the group consisting of titanium, zirconium, tin, zinc, and the metal nanoparticles consist of at least one element selected from the group consisting of: Ag, Au, Ni, Cr, Cu, Pt, Pd, more preferably from Ag, Cu, Ni or Au, more preferably from Ag or Au.

16. The glazing as claimed in the preceding claim, in which a first element is titanium and a second element is selected from the group consisting of silicon, zirconium, tin, indium, zinc, and the metal nanoparticles consist of at least one element selected from the group consisting of: Ag, Au, Ni, Cr, Cu, Pt, Pd, more preferably from Ag, Cu, Ni or Au, more preferably from Ag or Au.

17. A piece of equipment for carrying out the process as claimed in one of claims 1 to 13, said piece of equipment comprising, in combination:

- a cathode sputtering device comprising at least one chamber under vacuum,
- a target consisting of a mixture of a first constituent made of a dielectric material consisting of an oxide, a nitride or an oxynitride of a first element and of a second constituent consisting of the metallic form of a second element, said target being set up in the chamber under vacuum,
- means for sputtering said target comprising means for introducing a plasma gas and means for generating a plasma from said gas,
- means for introducing, into said plasma, a third element different than the first element, in the form of a hydride, a halide or an organic compound of said third element,
- means for passing the substrate through said device, at a suitable speed for depositing, on a surface thereof, a layer of a coating consisting of metal nanoparticles of the second element dispersed in an inorganic matrix of an oxide, a nitride or an oxynitride of said first and third elements,
- means for recovering said substrate covered with said coating at the outlet of the device.

18. The piece of equipment for carrying out the process as claimed in one of claims 1 to 13, said equipment comprising, in combination:

- a cathode sputtering device comprising at least one chamber under vacuum,
- a first target consisting of a mixture of a first constituent made of a dielectric material consisting of an oxide, a nitride or an oxynitride of a first element, said first target being set up in the chamber under vacuum,
- a second target made of a second constituent consisting of the metallic form of a second element, said second target being set up in the chamber under vacuum,
- means for simultaneous co-sputtering of the two targets comprising means for introducing a plasma gas and means for generating a plasma from said gas,
- means for introducing, into said plasma, a third element different than the first element, in the form of a hydride, a halide or an organic compound of said element,
- means for passing the substrate through said device, at a suitable speed for depositing, on a surface thereof, a layer of a coating consisting of metal nanoparticles of the second element dispersed in an inorganic matrix of an oxide, a nitride or an oxynitride of said first and third elements,
- means for recovering said substrate covered with said coating at the outlet of the device.

19. The use of the equipment as claimed in one of claims 16 or 17 for manufacturing colored glass substrates comprising a coating consisting of an inorganic matrix of an oxide, a nitride or an oxynitride of a first and of a third element, in which metal nanoparticles of a second element are dispersed.

EP 3 386 929 B1

**FIGURE**

## RÉFÉRENCES CITÉES DANS LA DESCRIPTION

**Documents brevets cités dans la description**

- US 6214183 B
- EP 0149408 A
- WO 2010106370 A
- US 5876854 A
- US 5976678 A
- US 2001018393 A

**Littérature non-brevet citée dans la description**

- **H. B. LIAO ; WEIJIA WEN ; G. K. L. WONG.** Preparation and optical characterization of Au/SiO2 composite films with multilayer structure. *Journal of Applied Physics,* 2003, vol. 93 (4485
- **CHAN KEE WAH et al.** *Materials Chemistry and Physics,* 2013, vol. 140, 37-41
- **BEYENE H et al.** *Plasmonics,* 2011, vol. 6, 255-260
- **MIEWON JUNG et al.** *Journal of Sol-Gel Science and Technology,* 2000, vol. 19, 563-568